**Europäisches Patentamt**

**European Patent Office**

**Office européen des brevets**

(19)

(11) Veröffentlichungsnummer: **0 236 526**

**A1**

(12) **EUROPÄISCHE PATENTANMELDUNG**

(21) Anmeldenummer: **86103302.5**

(22) Anmeldetag: **12.03.86**

(51) Int. Cl.4: **H01L 31/10** , **H01L 29/78**

(43) Veröffentlichungstag der Anmeldung:
**16.09.87 Patentblatt 87/38**

(84) Benannte Vertragsstaaten:
**FR IT NL**

(71) Anmelder: **ITT INDUSTRIES INC.**
**320 Park Avenue**
**New York, NY 10022(US)**

(72) Erfinder: **Thompson, Georg Horrace Brooke**
**20 Hoestock Road**
**Sawbridgeworth Herts CM 21 OD2(GB)**

(74) Vertreter: **Morstadt, Volker, Dipl.-Ing. et al**
**c/o Deutsche ITT Industries GmbH**
**Patent/Lizenzabteilung Postfach 840**
**Hans-Bunte-Strasse 19**
**D-7800 Freiburg/Brsg.(DE)**

(54) **Optischer Feldeffekttransistor.**

(57) Ein Photodetektor in Form eines optischen Feldeffekttransistors besteht aus einem halbisolierenden InP-Substrat (1), einem p+InP-Gatebereich (2), einer n⁻-InGaAs-Kanalschicht (3) und aus Source-und Drainkontakten - (5, 6). Das zu detektierende Licht fällt durch die Unterseite des halbisolierenden InP-Substrats (1) ein. Die n⁻-InGaAs-Kanalschicht (3) ist im Vergleich zu einer Kanalschicht eines normalen Junction-Feldeffekttransistors dicker aber schwächer dotiert, um eine effiziente Lichtabsorption und eine geringe Kapazität zwischen Gate und Source zu erreichen. Die Source-und Drainkontakte (5, 6) bestehen zur Vergrößerung des Absorptionsbereichs aus einer fingerförmigen ineinandergreifenden Kammstruktur. Alternativ hierzu setzt sich der Kanalbereich aus zwei Schichten zusammen. Einer leicht dotierten Schicht, die die Aufgabe hat, durch Licht erzeugte Ladungsträger zu einer zweiten stärker dotierten Schicht, der aktiven Kanalschicht, zu leiten. Die zweite stärker dotierte Schicht weist verkleinerte Ausmaße auf, und auf ihr sind streifenförmigen Source-und Drainkontakte angebracht. Die Struktur des optischen Feldeffekttransistors bietet eine problemlose Integration mit anderen Bauelementen an.

Fig.1.

Licht

EP 0 236 526 A1

### Optischer Feldeffekttransistor

Die Erfindung betrifft Photodetektoren und insbesondere Photodetektoren bildende optische Feldeffekttransistoren, die ihre Anwendung in optischen Fasersystemen finden. Die typischen Photodetektoren solcher Systeme weisen Avalanche-Photodioden auf oder bestehen aus einer Kombination von PIN-Diode und Feldeffekttransistor (PIN-FET-Kombination), wobei der Ausgang der PIN-Diode mit dem Gate des Feldeffekttransistors verbunden ist.

Ein herkömmlicher Verbindungshalbleiter Junction-Feldeffekttransistor weist grundsätzlich ein halbisolierendes Substrat mit einem relativ gut leitenden Kanalbereich auf. Source-, Drain-und Gatekontakte sind an der gleichen Seite des Kanalbereichs angebracht. Bei der Verwendung solch einer Vorrichtung als optischer Feldeffekttransistor ergibt sich nur ein kleiner Absorptionsbereich für durch die Oberfläche einfallendes Licht. Bei einer alternativen Struktur eines optischen Feldeffekttransistors ist das Gate unter dem Kanalbereich angebracht, und der Verarmungsbereich erweitert sich eher zu der Oberfläche hin, durch die das Licht einfällt, als von ihr weg. Diese alternative Struktur bewirkt einen größeren Absorptionsbereich, der von dem Kanalbereich bis zu der Oberfläche, durch die das Licht einfällt, ausgedehnt ist. Solch eine Struktur wurde schon als ein optischer Feldeffekttransistor in "New minority hole sinked photoconductive detector" von C.Y.Chen et al, Appl. Phys. Lett. 43 (12) 15. Dezember 1983 S. 115 veröffentlicht. Für die Struktur wurde darin ein Abstand zwischen Source-und Drainkontakt von 4000 nm vorgeschlagen, wobei sich im Hinblick auf den großen Gatebereich eine hohe Kapazität ergibt. Der Abstand zwischen Source-und Drainkontakt kann idealerweise auf 1000 nm reduziert werden, um die Ladungsträgertransportzeit und das Rauschen des Feldeffekttransistors zu verringern, sowie die cut-off Frequenz zu erhöhen. Wenn jedoch der Abstand zwischen Source-und Drainkontakt bei der bekannten Struktur derart verringert wird, ergibt sich hieraus für das durch die Oberfläche einfallende Licht ein kleiner Absorptionsbereich in der Kanalschicht.

Der optisch empfindliche Feldeffekttransistor vereint in sich prinzipiell die Detektions-und die Verstärkungsfunktionen und erreicht wegen des Wegfalls der separaten Kapazität der PIN-Diode eine höhere Empfindlichkeit bei hohen Modulationsfrequenzen.

Der Erfindung liegt das Problem zugrunde, eine Vorrichtung zu finden, bei der das Licht in den kleinen Kanalbereich unter dem Gatebereich des Feldeffekttransistors einfällt und bei der sichergestellt ist, daß das einfallende Licht im Kanalbereich vollständig absorbiert wird. Das Problem wird bei einer gattungsgemäßen Vorrichtung durch die kennzeichnenden Merkmale des Anspruchs 1 gelöst.

Weitere Ausgestaltungen der Erfindung sind den übrigen Patentansprüchen 2 bis 10 zu entnehmen.

Ein erfindungsgemäßer Weg, den Abstand zwischen Source-und Drainkontakt zu verkleinern, ist die Verwendung von Source-und Drainkontakten, die eine fingerartige ineinandergreifende Kammstruktur aufweisen und somit einen nahezu quadratischen aktiven Bereich bilden, wobei die Vorrichtung von der Substratseite her belichtet wird. Dies ist möglich, seitdem transparente Substrate, z.B. transparentes InP, verwendet werden. Die absolute Kapazität zwischen Source und Gate darf nicht vergrößert werden, denn dies würde sich wieder nachteilig auf die Empfindlichkeit auswirken. Um eine Vergrößerung der Fläche des Kanalbereichs zu umgehen, wird die Dicke vergrößert und die Dotierung reduziert, so daß das Gate noch genügend hoch geladen werden kann, um den Kanal zu verarmen. Diese Zunahme der Dicke des Kanalbereichs ist sehr wichtig, un die vollständige Absorption des normal einfallenden Lichts zu gewährleisten.

Aufgrund dieser Veränderungen ergibt sich ein optischer Feldeffekttransistor mit ungewöhnlicher Geometrie und einigen weiteren ungewöhnlichen Merkmalen. Der Abstand zwischen Source und Drain bleibt der gleiche, aber die Dicke des Kanalbereichs ist nicht, wie erwartet werden konnte, fünfmal kleiner, sondern etwa dreimal größer. Ebenfalls sind Source-und Drainkontakte um das Zehn-bis Fünfzehnfache verbreitert und der Strom je Breiteneinheit umgekehrt proportional verkleinert. Aufgrund des geringen Source-Stroms pro Breiteneinheit können Source-und Drainkontakte eine sehr geringe Dicke in Richtung des Stromflusses in dem Kanalbereich aufweisen. Diese Dicke ist gleich groß oder noch kleiner als der Abstand zwischen Source-und Drainkontakt. Wenn der Gatebereich in herkömmlicher Anordnung zwischen Source-und Drainkontakten auf der Oberseite des Kanalbereichs angebracht wird, werden sich die Streufelder benachbarter fingerförmiger ineinandergreifender strukturierter Gatebereiche dort überlagern, wo sie sich unter den Source-und Drainkontakten quer über dem dicken Kanalbereich ausbreiten. Infolgedessen ist es vorteilhaft, auf den normalen Gatebereich, der auf der Oberseite des Kanalbereichs angebracht ist, zu verzichten und diesen durch ein an der Unterseite des Kanalbereichs angebrachten flächenhaften Gatebereich zu ersetzen.

Ein erster Teil der Erfindung besteht aus einem optischen Feldeffekttransistor. Dieser optische Feldeffekttransistor besteht aus einem halbisolierenden optisch transparenten Substrat, einem optisch transparenten Gatebereich · eines Leitungstyps, der auf der einen Seite des Substrats angebracht ist, einem Kanalbereich entgegengesetzten Leitungstyps und aus auf dem Kanalbereich kontaktierten Source-und Drainkontakten. Der Transistor detektiert Licht, das von der gegenüberliegenden Seite des Substrats in der Nähe des Kanalbereichs einfällt.

Ein zweiter Teil der Erfindung betrifft ein Verfahren zur Herstellung des erfindungsgemäßen optischen Feldeffekttransistors. Beim Verfahren werden die Ätzschritte zur Herstellung einer Vertiefung auf der einen Seite des halbisolierenden InP-Substrats durchgeführt, wird diese eine Seite des Substrats zur Bildung einer $p^+$InP Schicht mit Zink diffundiert, wird mittels Flüssigphasen epitaxie eine $n^-$InGaAs-Schicht auf die $p^+$InP-Schicht aufgebracht, wobei die Vertiefung aufgefüllt und eine im wesentlichen planare Struktur geschaffen wird, wird die $n^-$InGaAs-Schicht vom InP-Substrat weggeätzt, sofern sie sich neben der ausgefüllten Vertiefung befindet, werden Source-und Drainkontakte auf die in der Vertiefung befindlichen $n^-$InGaAs-Schicht angebracht und werden diese durch die ausgefüllte Vertiefung von der $p^+$InP-Schicht isoliert. Ferner wird ein Gatekontakt auf der $p^+$InP Schicht gebildet.

Ausführungsbeispiele der Erfindung sind nachstehend anhand der Figuren 1 bis 3 beschrieben. Es zeigen:

Fig. 1 ein Ausführungsbeispiel des erfindungsgemäßen optischen Feldeffekttransistors im Teilschnitt,

Fig. 2 ein anderes Ausführungsbeispiel des erfindungsgemäßen optischen Feldeffekttransistors im Teilschnitt, und

Fig. 3a 3b u.3c einzelne Teilschritte bei der Herstellung des gem. Fig. 1 dargestellten erfindungsgemäßen optischen Feldeffekttransistors.

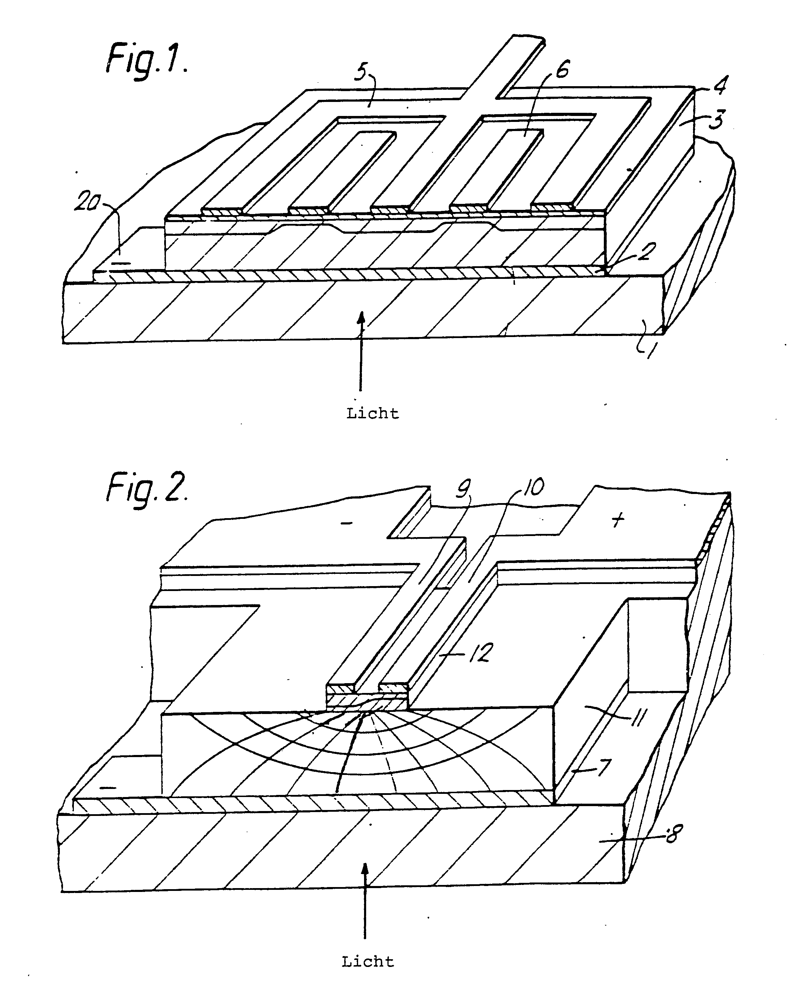

Ein Ausführungsbeispiel ist in Fig. 1 dargestellt. Der optische Feldeffekttransistor gem. Fig. 1 ist aus einem halbisolierenden InP-Substrat 1, aus einem $p^+$InP-Gatebereich 2, aus einer $n^-$InGaAs-Kanalschicht 3, aus einer dünnen $p^+$InGaAs-Schicht 4 und aus fingerartigen ineinandergreifenden Source-und Drainkontakten 5, 6 aufgebaut. Die Drainkontakte 6 sind auf die gleiche Art (Fig. 1) wie die Sourcekontakte 5 miteinander verbunden.

In Fig. 1 ist nur die halbe Vorrichtung abgebildet. Der $p^+$InP-Gatebereich 2 ist ganzflächig an der Unterseite der $n^-$InGaAs-Kanalschicht 3 ausgebildet und ragt nur an einer Stelle 2a über die $n^-$InGaAs-Kanalschicht 3 zur Anbringung eines · genügend großen elektrischen Kontakts hinaus. Der eingebettete Gatebereich erfordert keine Selbstjustierung beim Herstellungsverfahren, wie das der Fall wäre, wenn mehrere Gatebereiche auf der Oberseite der Kanalschicht angebracht wären, und er wirkt stärker auf die Kanalbereich, als wenn er unter den Source-und Drainkontakten angeordnet wäre. Zusätzlich trägt er noch etwas zur Leitfähigkeit bei. Typische Dotierungskonzentrationen und Schichtdicken der Schichten 2 bis 4 der Figur 1 sind im folgenden dargestellt.

|  | Dotierungskonzentration | Schichtdicke |
|---|---|---|
| $p^+$InP-Gatebereich 2 | $2 \times 10^{18}$ cm$^{-3}$ | 500 nm |
| $n^-$InGaAs-Kanalschicht 3 | $2 \times 10^{15}$ cm$^{-3}$ | 2000 nm |
| $p^+$InGaAs-Schicht 4 | $5 \times 10^{17}$ cm$^{-3}$ | 70 nm |

Das Verarmungsgebiet wird unter Verwendung eines negativ geladenen Gatebereichs und einem dazu positiv geladenen Drainkontakt unter Berücksichtigung der Ladung des Sourcekontakts entleert.

Die Struktur aus Fig. 1 kann in einen optischen Transistor mit hoher Elektronenbeweglichkeit unter Verwendung einer $n^+$Schicht mit höherer Bandlücke anstelle der $n^-$InGaAs-Kanalschicht 3, z.B. einer InP-Schicht oder einer InAlAs-Schicht, und mit einer geeigneten Schichtdicke der Schicht 4 umgewandelt werden. Die Kanalschicht 3 sollte nur sehr schwach dotiert sein. Die Kanalschicht 3 weist dann ein zweidimensionales Elektronengas auf und ist direkt unter der $p^+$InGaAs-Schicht 4 angeordnet. Dies führt zu einer besseren Elektronenbeweglichkeit. Die Source-und Drainkontakte 5, 6 müssen dabei genügend hoch legiert oder geeignet implantiert sein, um durch die $p^+$InGaAs-Schicht 4 in die Kanalschicht 3 einzuwirken.

In Fig. 2 ist ein weiteres Ausführungsbeispiel dargestellt, das einen auf einem halbisolierenden Substrat 8 aufgebrachten breiten ausgedehnten $p^+$InP-Gatebereich 7 aufweist, der einem Feldeffekttransistor zugehörig ist und der keine fingerartige ineinandergreifende Source-und Drainelektroden aufweist. Die streifenförmigen Source-und Drainkontakte 9, 10 dieses Feldeffekttransistors sind derart angeordnet, daß die in der Kanalschicht 11 entstandenen Ladungsträger durch die Feldverteilung vom gesamten Bereich des Gates auf den schmalen Bereich der streifenförmigen Kanalschicht 12 fokusiert werden. Dieser Kanalbe-

3

reich besteht aus zwei Teilen, einer dicken sehr reinen (n⁻⁻)InGaAs-Kanalschicht 11, die direkt auf den p⁺ InP-Gatebereich 7 aufgebracht ist und einer dünnen aber höher dotierten (n)InGaAs-Kanalschicht 12, die auf der (n⁻⁻)InGaAs-Schicht 11 aufgebracht ist und deren Breite durch die Anpassung an Source-und Drainkontakte 9, 10 und dem dort dazwischenliegenden Bereich begrenzt ist. Diese Kontakte 9, 10 liegen parallel zueinander und parallel zur (n)InGaAs-Kanalschicht 12. Bevor sich die Hauptraumladung in der (n)InGaAs-Kanalschicht 12 ergibt, weisen die Feldlinien einen konvergierenden Verlauf zwischen dem p⁺InP-Gatebereich 7 und der (n)InGaAs-Kanalschicht 12 auf, wie es in Fig. 2 dargestellt ist. Die durch Lichteinfall erzeugten Ladungsträger werden hierdurch in den kritischen Bereich, in die (n)InGaAs-Kanalschicht 12, geführt. Diese Struktur weist gegenüber der Struktur aus Fig. 1 eine etwas geringere Kapazität auf, sie erfordert aber wegen der höheren Stromdichte in der (n)InGaAs-Kanalschicht 12 bessere Kontakte.

Die Struktur aus Fig. 2 kann in einen optischen Transistor mit hoher Elektronenbeweglichkeit umgewandelt werden, indem die (n)InGaAs-Kanalschicht 12 durch eine dünne n⁺InP-Schicht ersetzt wird. Der Kanalbereich weist dann in der direkt unter der n⁺InP-Schicht liegenden n⁻⁻InGaAs-Schicht 11 ein zweidimensionales Elektronengas auf. Dies führt zu einer besseren Elektronenbeweglichkeit. Typische Dotierungskonzentrationen und Schichtdicken der Schichten 7, 11 und 12 aus Fig. 2 sind im folgenden dargestellt:

| | Dotierungs-konzentration | Schichtdicke |
|---|---|---|
| Gatebereich 7 | $2 \times 10^{18}$ cm$^{-3}$ | 500 nm |
| n⁻⁻InGaAs-Kanalschicht 11 | $5 \times 10^{14}$ cm$^{-3}$ | 3000 nm |
| n⁻⁻InGaAs-Kanalschicht 12 | $3 \times 10^{16}$ cm$^{-3}$ | 200 nm |

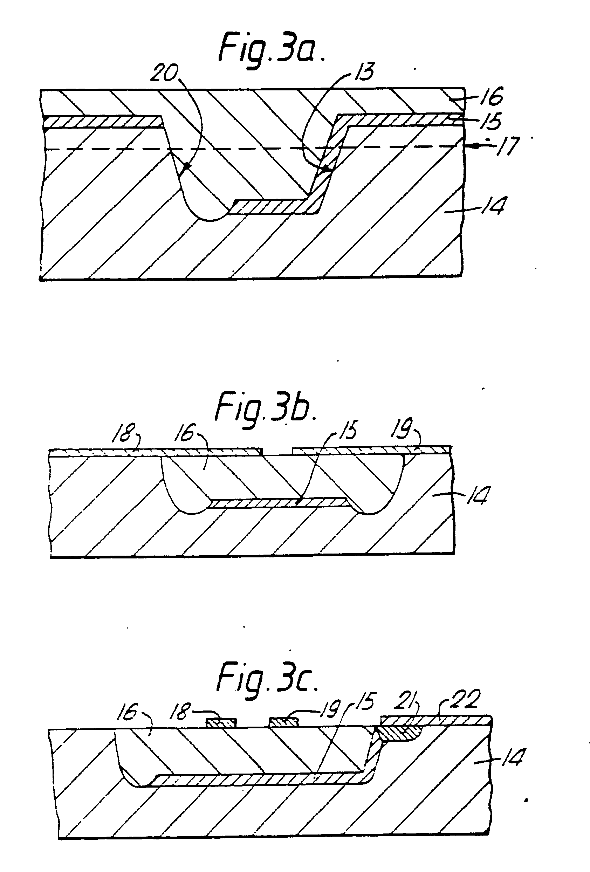

Ein prinzipielles Herstellungsverfahren der erfindungsgamäßen Anordnung ist in Fig. 3 schematisch dargestellt. Es werden Vertiefungen 13 (Fig. 3a) aus einem halbisolierenden InP-Substrat 14 herausgeätzt, durch die Oberfläche auf der Seite der Vertiefungen wird anschließend Zink eindiffundiert, um eine p⁺InP-Schicht 15 zu schaffen, wobei ein Teil hiervon schließlich den Gatebereich bildet. Die p⁺InP-Schicht 15 wird an drei Seiten 20 der Vertiefung mit Hilfe einer geeigneten Maske und einer entsprechenden Lackbeschichtung weggeätzt. Auf die gesamte p⁺InP-Schicht 15 läßt man mittels Flüssigphasenepitaxie eine n⁻InGaAs-Schicht 16 abscheiden, bis die Vertiefung geschlossen und eine im wesentlichen planare Oberfläche erreicht ist. Das Wafer wird nun mit einem nichtselektiven Ätzmittel ganzflächig so weit abgeätzt, bis das halbisolierende Substrat 14 neben den Vertiefungen 13 freigelegt wird, diese Grenze ist in Fig. 3a als Linie 17 dargestellt. Die verbleibende, örtlich begrenzte n⁻InGaAs-Schicht 16 grenzt mit ihrer Unterseite an die p⁺InP-Schicht 15. Fingerartige ineinandergreifende Source-und Drainkontakte 18, 19, wie sie mit den Bezugszeichen 5 und 6 in Fig. 1 dargestellt sind, werden auf der n⁻InGaAs-Schicht 16 als metallische Eingangskontakte aufgebracht, die auf das halbisolierende InP-Substrat 14 übergreifen (Fig. 3b). Der Gatekontakt 21 wird zwischen der p⁺InP-Schicht 15 (Gatebereich) und einer Metallschicht 22 angebracht (Fig. 3c). Die Figuren 3b und 3c stellen den gleichen Gegenstand aber in zwei rechtwinklig zueinander stehenden Orientierungen dar.

Die erfindungsgemäßen Strukturen der beiden Ausführungsbeispiele eignen sich zur monolithischen Integration mit zusätzlichen getrennten Feldeffekttransistoren auf einem gemeinsamen Substrat und weisen eine niedrige Kapazität auf. Sie sind dadurch zur Verwendung in empfindlichen optischen Empfängern geeignet. Der Kanalbereich des optischen Feldeffekttransistors, wie er in Fig. 2 dargestellt ist, kann genauso als Kanalbereich eines zusätzlichen getrennten Junction-Feldeffekttransistors benutzt werden. Die n⁺InP-Schicht und die undotierte InGaAs-Schicht, wie sie in optischen Feldeffekttransistoren mit hoher Elektronenbeweglichkeit benutzt werden, können auch als Kanalschicht zusätzlicher Feldeffekttransistoren mit hoher Elektronenbeweglichkeit angewendet werden. Der erfindungsgemäße optische Feldeffekttransistor, der auch optical embedded gate Feldeffekttransistor (OPEGFET) genannt wird, vereinigt in sich eine Vielzahl von Ausgestaltungen, die die Herstellung einer Struktur mit einer niedrigen Kapazität, an der das Gate beteiligt ist, ermöglicht. Diese Ausgestaltungen führen bei einem vergrößerten Absorptionsbereich, bei einer dicke-

4

ren Kanalschicht und bei niedereren Dotierungskonzentrationen zur effizienteren Absorption des einfallenden Lichts. Die niedrige Kapazität zwischen Source und Gate wird beibehalten. Das eingebettete Gate vom p-Leitungstyp liegt dabei unter der Kanalbereich, wobei der Kanalbereich über den gesamten Absorptionsbereich angeordnet ist. Ferner findet die Belichtung der Vorrichtung stärker durch die Substratoberfläche, als über die Außenfläche des Kanalbereichs statt. In der Praxis ist ein Ladewiderstand, der mit dem Gate in Serie geschaltet ist, erforderlich. Dieser kann in herkömmlicher Technik mit dem optischen Feldeffekttransistor auf dem gleichen Substrat integriert hergestellt und mit dem Gate verbunden werden.

**Ansprüche**

1. Optischer Feldeffekttransistor zum Nachweisen von Licht, **dadurch gekennzeichnet,** daß auf der einen Seite eines halbisolierenden optisch transparenten Substrats (1) ein optisch transparenter Gatebereich (2) eines bestimmten Leitungstyps angebracht ist und sich darauf ein Kanalbereich entgegengesetzten Leitungstyps mit Source-und Drainkontakten (5, 6) befindet.

2. Optischer Feldeffektransistor nach Anspruch 1 , dadurch gekennzeichnet, daß Source-und Drainkontakte (5, 6) eine fingerartige und ineinandergreifende Struktur aufweisen.

3. Optischer Feldeffekttransistor nach Anspruch 2, dadurch gekennzeichnet, daß das halbisolierende Substrat (1) aus InP, der Gatebereich (2) aus $p^+InP$ und der Kanalbereich aus $n^-InGaAs$ besteht.

4. Optischer Feldeffekttransistor nach Anspruch 3, dadurch gekennzeichnet, daß zwischen Kanalbereich und Source-und Drainkontakten (5, 6) eine p InGaAs-Schicht (4) angebracht ist.

5. Optischer Feldeffekttransistor nach Anspruch 2, dadurch gekennzeichnet, daß das halbisolierende Substrat (1) aus InP, der Gatebereich (2) aus $p^+InP$ und der Kanalbereich aus einer sehr niedrig dotierten n InGaAs-Schicht (3) besteht, sowie zwischen dem Kanalbereich und den Source-und Drainkontakten (5, 6) eine $n^+InP$-Schicht oder eine $n^+InAlAs$-Schicht angebracht ist.

6. Optischer Feldeffekttransistor nach Anspruch 1, dadurch gekennzeichnet, daß der Kanalbereich in der Weise mehrschichtig ausgebildet ist, daß er aus einer relativ dicken, dotierten Schicht (11) und einer höher dotierten streifenförmigen Schicht (12) besteht, wobei die streifenförmige Schicht (12) auf einem Teil der Oberfläche der niedrig dotierten Schicht (11) angeordnet ist, und daß Source-und Drainkontakte (9, 10) als parallel zueinander und zur Längsaschse der streifenförmigen Schicht (12) verlaufende, auf der streifenförmigen Schicht (12) angeordnete streifenförmige Kontakte ausgebildet sind.

7. Optischer Feldeffekttransistor nach Anspruch 6, dadurch gekennzeichnet, daß das halbisolierende Substrat (8) aus InP, der Gatebereich (7) aus $p^+InP$, die niedrig dotierte Schicht (11) aus $n^{--}InGaAs$ und die höher dotierte Schicht (12) aus n InGaAs besteht.

8. Optischer Feldeffekttransistor nach Anspruch 6, dadurch gekennzeichnet, daß das halbisolierende Substrat (8) aus InP, der Gatebereich (7) aus $p^+InP$, die niedrig dotierte Schicht (11) aus $n^{--}InGaAs$, und die höher dotierte Schicht (12) aus $n^+InP$ besteht.

9. Optischer Feldeffekttransistor nach einem der Ansprüche 1 bis 8, dadurch gekennzeichnet, daß im Betrieb der Gatebereich gegenüber dem Sourcekontakt negativ und der Drainkontakt gegenüber dem Sourcekontakt positiv, geladen ist.

10. Verfahren zur Herstellung des optischen Feldeffekttransistors nach Anspruch 1, gekennzeichnet durch folgende Verfahrensschritte:

a) Ätzen mindestens einer Vertiefung (13) in eine Seite eines halbisolierenden InP-Substrats (14),

b) Eindiffundieren von Zink auf dieser einen Seite des InP-Substrats (14) zur Erzeugung einer $p^+InP$-Schicht (15),

c) Entfernen der $p^+InP$-Schicht (15) am Rande (20) der Vertiefung (13) durch selektives Ätzen,

d) Abscheiden einer $n^-InGaAs$-Schicht (16) auf die $p^+InP$-Schicht (15) durch Flüssigphasenepitaxie, derart, daß die Vertiefung (13) aufgefüllt und eine im wesentlichen planare Oberfläche geschaffen wird,

e) Wegätzen der $n^-InGaAs$-Schicht (16) so weit, bis neben der Vertiefung (13) das halbisolierende InP-Substrat (14) wieder freigelegt ist,

f) Aufbringen der Source-und Drainkontakte (18, 19) auf die $n^-InGaAs$-Schicht (16), und

g) Aufbringen eines Gatekontakts (21) auf die $p^+InP$-Schicht (15).

**Fig.1.**

Licht

**Fig.2.**

Licht

## Fig.3a.

## Fig.3b.

## Fig.3c.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int Cl 4) |
|---|---|---|---|
| D,A | APPLIED PHYSICS LETTERS, Band 43, Nr. 12, Dezember 1983, Seiten 1115-1117, New York, US; C.Y. CHEN et al.: "New minority hole sinked photoconductive detector" * Insgesamt * | 1,6,9 | H 01 L 31/10 H 01 L 29/78 |
| A | PATENTS ABSTRACTS OF JAPAN, Band 10, Nr. 42 (E-382)[2099], 19. Februar 1986; & JP-A-60 198 861 (FUJITSU K.K.) 08-10-1985 * Insgesamt * | 1 | |
| A | US-A-3 703 408 (M. BELASCO et al.) * Insgesamt * | 1,2 | |
| A | US-A-4 517 581 (G.H.B. THOMPSON) * Insgesamt * | 1,6-8 | RECHERCHIERTE SACHGEBIETE (Int Cl 4) H 01 L |
| A | GB-A-2 134 707 (SHARP K.K.) | | |
| A | PATENTS ABSTRACTS OF JAPAN, Band 6, Nr. 12 (E-91)[890], 23. Januar 1982; & JP-A-56 135 968 (CANON K.K.) 23-10-1981 ---  -/- | | |

Der vorliegende Recherchenbericht wurde für alle Patentansprüche erstellt

| Recherchenort DEN HAAG | Abschlußdatum der Recherche 29-10-1986 | Prüfer VISENTIN A. |
|---|---|---|

## EINSCHLÄGIGE DOKUMENTE

Seite 2

| Kategorie | Kennzeichnung des Dokuments mit Angabe, soweit erforderlich, der maßgeblichen Teile | Betrifft Anspruch | KLASSIFIKATION DER ANMELDUNG (Int Cl 4) |
|---|---|---|---|
| E,X | GB-A-2 168 527 (STC PLC)<br>* Insgesamt * | 1-10 | |

-----

RECHERCHIERTE
SACHGEBIETE (Int. Cl 4)

Der vorliegende Recherchenbericht wurde für alle Patentansprüche erstellt

| Recherchenort<br>DEN HAAG | Abschlußdatum der Recherche<br>29-10-1986 | Prüfer<br>VISENTIN A. |
|---|---|---|